# EUROPEAN PATENT APPLICATION

(11) **EP 2 315 249 A1**
(43) Date of publication of application: **27.04.2011**
(21) Application number: 09425429.9
(22) Date of filing: 26.10.2009
(51) Int. Cl.: H01L 27/146, H01L 31/0203, H01L 31/0232

(54) **Semiconductor sensor for detecting electromagnetic radiation**

(71) Applicant: Fondazione Bruno Kessler, 38122 Trento (IT)
(72) Inventor: Piemonte, Claudio, 38057 Pergine (IT)
(74) Representative: Borsano, Corrado

(57) **Abstract**

A semiconductor sensor for detecting a radiation comprising a substrate (3) having an inactive layer (7) formed thereon which has a sensitive layer (6) adapted to detect a high radiation formed thereon. A portion of the light sensitive layer (6) has a metal layer (8) attached thereto. A scintillator overlaps with the sensitive layer (6) and metal layer (8). A bonding wire (10) branches from said metal layer. Said sensor is shaped so that, according to a section of the sensor, said metal layer (8) is at a lower height with respect to the scintillator crystal (1), so that the bonding wire does not interfere therewith. Such a result is obtained by tapering the thickness of said inactive layer (7) and/or interposing a transparent layer (14) between said sensitive layer (6) and said scintillator crystal (1).

## Description

### Field of the invention

The present invention relates to a semiconductor sensor for detecting a light radiation.

### State of the art

Radiation detecting systems are known. Among them, there are known systems using a scintillator to convert the radiation intended to be detected into another type of radiation, usually light. These systems generally cover wide surfaces, therefore they are made of several elementary squares or pixels which are sensitive to an electromagnetic radiation, placed side by side and covered by one or more scintillators, so as to detect the light therefrom. A substrate supports said elementary squares and allows them to be electrically connected for transferring the electrical signals detected by an external device to which the sensor system is adapted to be connected.

In particular, a silicon sensor comprises an inactive layer which is insensitive to the light radiation because it is made of highly doped silicon and therefore not emptied from electrical charges under operational conditions. There is a sensitive layer thereon, capable of detecting an electromagnetic radiation, usually having at least one dielectric layer thereon required for electromechanical reasons and for creating an antireflective layer to the radiation from the scintillator crystal.

Such a sensor thus has a sensitive layer having a scintillator crystal attached thereto and the electrical signals are collected by each pixel by means of a metal element, so that every pixel is independent of the others.

Said metal element generally leads the electrical signals to the substrate, so that they are made externally available at the side opposite to the sensitive side. Thereby, the sensor may be advantageously soldered to an external circuit, etc.

The presence of the scintillator crystal attached to the active part of the sensor complicates the collection of the electrical signals produced by the active side of the sensor, because metal wires (referred to as bonding wires) are employed, each forming, close to one edge of a sensor, a sort of arch resting on the active side of the sensor, thus collapsing to reach the substrate. Such a configuration determines an interference with the application of the scintillator crystal to the sensor system. Indeed, the crystal may cover many pixels and every pixel needs a bonding wire connecting it to the substrate. Therefore, the bonding wire is an obstacle for placing the crystal on the sensor.

Its height may be changed but it is hardly possible to go below 100um, therefore the problem is persisting.

### Summary of the invention

It is an object of the present invention to provide a sensor for detecting a light radiation, adapted to solve the aforesaid problem.

It is a subject matter of the present invention a semiconductor sensor for detecting a light radiation which, in accordance with claim 1, comprises a substrate having an inactive layer attached/formed thereon which has a sensitive layer attached/formed thereon, a metal layer being attached at least in a portion of said sensitive layer, a curved bonding wire adapted to connect part of said metal layer to said substrate, a scintillator overlapping said sensitive layer; the sensor being characterized in that at least said part of said metal layer is spaced apart from said scintillator, so that said bonding wire does not interfere with the scintillator.

According to a preferred variation of the invention, the sensor comprises a further transparent layer interposed between said sensitive layer and said scintillator, of a thickness such that it spaces out the scintillator from the part of metal layer having said bonding wire connected thereto, so as to avoid the interference between the bonding wire and the scintillator.

According to another variation of the invention, said sensor has a tapered edge in correspondence with the sensitive side having said metal layer attached thereto, which has said bonding wire branching therefrom.

According to a further variation of the invention, a sensor may simultaneously comprise a transparent layer and a taper.

According to another aspect of the invention, it solves the above-mentioned problems by providing a method of manufacturing a sensor for detecting a light radiation. Therefore, it is also a subject of the present invention a method of manufacturing a semiconductor sensor for detecting an electromagnetic radiation, in accordance with claim 9.

Advantageously, said tapering is preferably carried out by means of a physical etching. Also, carrying out a physical etching for both performing a pre-cut of the silicon slice and making said taper is convenient, due to the possibility of implementing sensors of any shape.

In case particular shapes are identified, such as for example a circular shape, which optimize the sensitive area of the sensor, carrying out the completion of the cutting operation by means of a further physical etching is advantageous at the end of every other machining operation.

Said electromagnetic radiation may be any light radiation, visible light, UV, IR, etc. The dependent claims describe preferred embodiments of the invention, forming an integral part of the present description.

### Brief description of the drawings

Further features and advantages of the invention will be more apparent in view of the detailed description of preferred, but not exclusive, embodiments of a semiconductor sensor for detecting a light radiation, shown by way of non-limiting example, with the aid of the accompanying drawings in which:

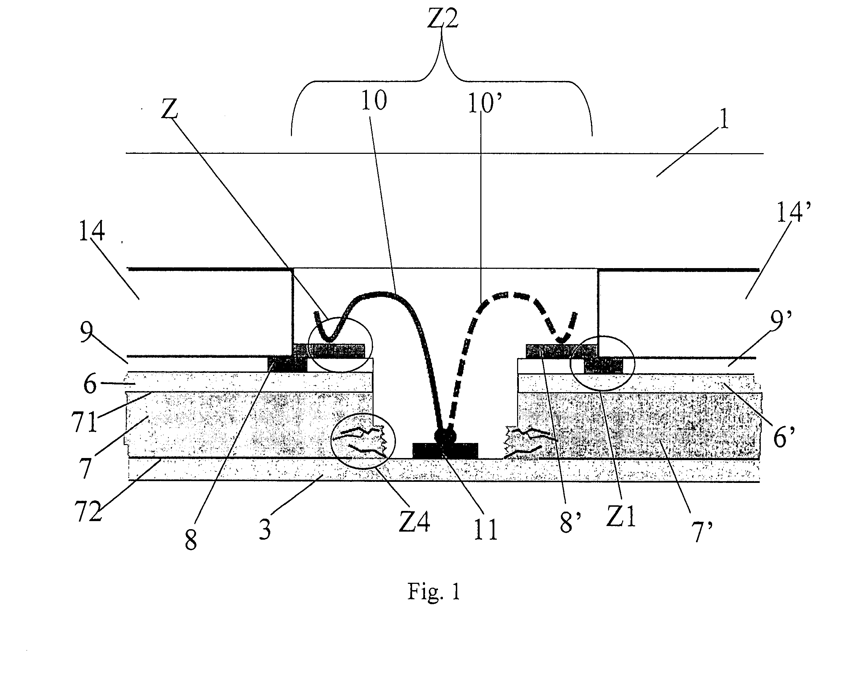

Figure 1 depicts a cutaway view of a first variation of a portion of a sensor in accordance with the present invention, adjacent to a similar sensor, where the interposition of a transparent filler layer between a sensitive zone of the sensor and the scintillator is provided, which is adapted to keep said scintillator lifted and spaced out with respect to the metal layer having the bonding wire branching therefrom;

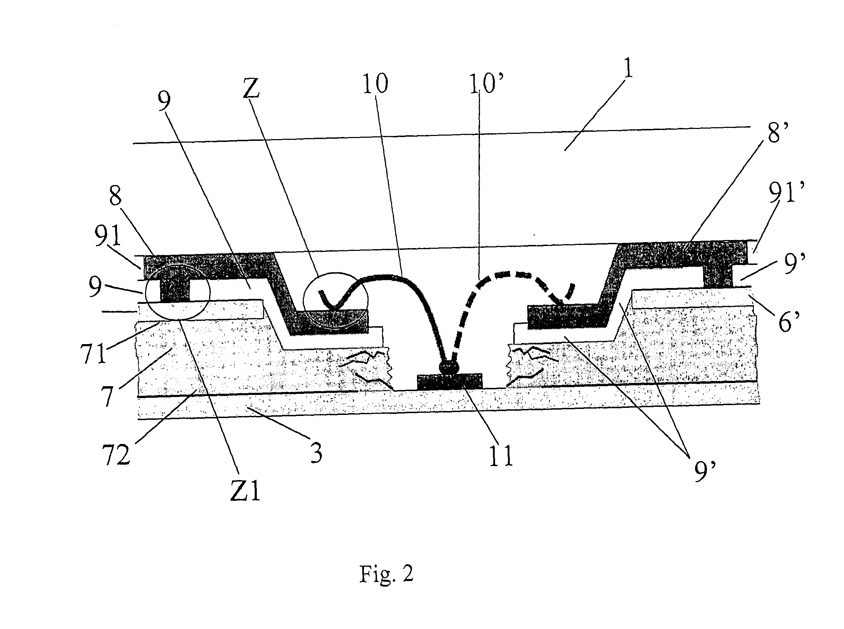

Figure 2 depicts a cutaway view of a second variation of a portion of a sensor in accordance with the present invention, adjacent to a similar sensor, where one edge of said sensor is tapered so that the connection of the bonding wire to said edge is not an obstacle for overlapping the scintillator crystal.

The same reference numerals and letters of the figures identify the same elements or components.

### Detailed description of a preferred embodiment of the invention

A semiconductor sensor in accordance with the present invention is described with the aid of Figures 1 and 2, in particular it comprises a substrate 3, e.g. common to a plurality of sensors or pixels, an inactive layer 7, a first face 71 thereof having a sensitive layer 6 attached/formed thereon adapted to detect an electromagnetic radiation, particularly a light radiation. A metal layer 8 is attached to a portion of said sensitive layer 6, adapted to collect the detected signals from the sensitive layer 6 and make them available to the bonding wire.

Said inactive layer 7 may consists of a slice of silicon or a material with similar features.

A dielectric layer 9 covers all the remaining portions of the sensitive layer which are not directly covered by said metal layer 8.

Therefore, said metal layer 8 directly contacts the sensitive layer 6 in a zone Z1, while for the remaining part thereof it extends over said dielectric layer 9.

An at least initially fluxible layer such as grease or glue or resin 91, may be deposited as a filler on dielectric portions 9 up to the level of said metal layer, so as to implement a flat surface on which a scintillator crystal 1 may be attached.

In addition to mechanical functions of filling, such a layer of grease, glue, resin 91 may also carry out optical functions of filtering an electromagnetic radiation crossing the scintillator 1.

Substrate 3 in correspondence with at least one edge of the sensor comprises a so-called bonding pad 11 i.e. a metal pad. By forming an arch, the bonding wire 10 connects said metal layer 8 to said bonding pad 11 of the substrate 3.

For removing the mechanical interference between the bonding wire 10 and the scintillator crystal 1, the portion Z of the metal layer 8 for collecting the electrical signals, according to the sections shown in the variations of Figures 1 and 2, is placed at a lower level with respect to the attaching surface of the scintillator crystal 1, so that said bonding wire does not interfere with the scintillator crystal 1.

A first variation of the invention, schematized in Figure 1, provides for the sensor to be of uniform thickness, while a transparent filler layer 14 having the scintillator crystal 1 applied thereto is applied to the dielectric layer. It is preferred that said filler layer 14 is made of epoxylic material. The thickness of such an epoxylic layer 14 is such to ensure the non-interference between the scintillator crystal 1 and the bonding wire 10. It is preferred that said epoxylic layer completely covers said dielectric layer 9 and possibly only partially said metal layer 8.

The epoxylic layer may consist of a photoresist that is deposited one or more times per spinning on the silicon slice when manufacturing the sensor. The epoxylic deposit portions possibly deposited on the portions Z of the metal layer 8 intended to the connection by means of the bonding wire 10 may be removed by lithography. The thicknesses of said transparent filler layer may range from 20 to 200um. The transparence of the deposited layers is higher than 90% on the whole spectrum of the visible light.

In the preferred variation of Figure 2, said sensor displays a reduction of its thickness in relation to the first face 71 having the sensitive layer 6 of the sensor attached/formed thereon, while the second face 72, opposite to said first face 71, is flat. By covering it, the dielectric layer 9 follows the valley obtained in the first face 71 of the inactive layer 7. Also the metal layer 8 follows such a valley spacing out from scintillator 1.

In both the preferred embodiments, while continuing to form an arch, the bonding wire connects the metal layer 8 to the bonding pad 11, attached to substrate 3, without interfering with the scintillator crystal 1 overlapping the sensor.

It is preferred that said valley, or equally said transparent filler layer 14 measures at least 100um for allowing the bonding wire to be easily placed.

The two solutions may be combined with each other, thus implementing a less tapered zone in the inactive thickness 7 and a cover with filling layer 14 of more modest thickness, for example.

Such a valley or taper of the inactive layer 7 may be advantageously obtained by DRIE etching.

Even if more complicated, said second variation advantageously has a double advantage as compared to the first variation:
- it allows a better optical coupling because there is not any intermediate layer that, even if limiting, absorbs a portion of radiation crossing the scintillator, therefore it better lends itself for applications with ultraviolet light because there is not any filling layer of epoxylic material and thus there is not any radiation absorptions;
- as the scintillator crystal is very close to the sensor, the light therefrom towards other pixels or towards the edge is avoided from dispersing/leaking.

Finally, a further advantage is recognizable in terms of assembling, indeed, with a sensor tapered at the edge zone, a connection with the narrower bonding wire may be obtained, i.e. the bonding pad 11 may be placed closer to the sensor, thus reducing the inactive spaces of a sensor, or between several adjacent sensors. According to another aspect of the invention, it solves another problem being that of cutting the sensor. Indeed, by the known methods of cutting the sensor from a silicon slice, mechanical means such as a saw or a laser are normally employed, which imply a partial damage of the sensor edge, for this reason a sensor edge zone remains damaged upon the cutting operation. The sensitive zone 6 should not be affected by the damage in order not to deteriorate the electrical features of the sensor. Therefore, in a sensor with pixels placed side by side, as shown in both Figures 1 and 2, an inactive zone Z2 is identified between the sensitive layer 6 of a first sensor and the sensitive layer 6' of a second sensor adjacent to the former. Therefore, the wider the extension of the damage inside the sensor upon the cutting operation, the wider the space wasted in a sensor comprising several elementary sensors or pixels.

Since the cut is also known to create a damaged zone affecting, transversally to the edge of the cut part, an area of about 100um in depth and since the thickness of the epitaxial silicon layer is of various hundreds of microns, then, thinning the inactive layer, preferably close to the first face 71 thereof facing the sensitive layer 6 and leaving its opposite face 72 flat, it is obtained the damaged zone tending to affect a limited zone confined towards said opposite face 72, thus avoiding the sensitive layer 6 from being affected. Thereby the extension of said inactive zone may be strongly limited, and even cancelled.

Therefore, in both cases, a physical etching DRIE may be advantageous, at least for carrying out a pre-cut facilitating the damage zone Z4 to move away from the sensitive face/layer 6, during a following complete cut of the silicon slice.

Therefore, by means of the method object of the present invention, not only the problem of the interference between the bonding wire and the scintillator crystal is advantageously solved, but the problem of confining the damage zone Z4 of the sensor far from the sensitive layer 6 is also solved, so that the extension of the inactive zone Z2 may be reduced.

According to the present invention, in order to reduce the inactive zone between two adjacent pixels or pixel rows, a physical etching DRIE (Deep Reactive Ion Etching) is used, preferably during the manufacturing process. Said etching may be conducted both for completely cutting the inactive layer 7, and for carrying out a partial cut, to be possibly completed by means of a following mechanical action.

A DRIE etching advantageously allows deep grooves to be performed in the silicon, thus obtaining highly vertical peripheral walls and causing a damage limited to a few microns from the edge. In order to maximize the simplification of the manufacturing process, it is preferred to carry out a partial cut with such a DRIE technique over a depth of at least d= 1007 ÷ 200um underneath said sensitive layer 6. Therefore, the complete cutting operation may be completed by a mechanical method inside the previously defined groove. This variation of the method is less efficient because there remains a portion of damaged silicon protruding beyond the vertical part obtained by means of said DRIE process, but it simplifies very much the manufacturing of the sensors because, at the output of the DRIE machine, the slice is still easy to be handled as a whole and therefore it may be further machined. The inactive zone of the sensor may be reduced to few tenths of microns in both cases.

An identical DRIE etching may be advantageously conducted for tapering said inactive layer 7 in order to implement said second variation of the invention and for dramatically reducing the thickness of the same layer at the cutting zone. Such a thickness reduction, as mentioned above, may be thus intended both as a tapering and as a pre-cut to be completed with a following cutting operation.

Performing both the tapering or pre-cutting operation and the complete cutting operation of the sensor by means of DRIE etchings implies the further advantage of being able to shape an elementary sensor with shapes other than the rectangular shape. In particular, shapes adapted to reduce said inactive zones may be obtained, thus optimizing the ratio of the active and total areas.

According to a preferred variation, said elementary sensors or pixels are of circular shape, so that upon approaching two or more pixels, the air portion left free may be advantageously employed for connecting the bonding wires.

The elements and features disclosed in the various preferred embodiments may be combined without departing, however, from the scope of protection of the present application.

## Claims

1. A semiconductor sensor for detecting an electromagnetic radiation comprising a substrate (3) having an inactive layer (7) attached/formed thereon which has a sensitive layer (6) attached/formed thereon, a metal layer (8) being attached at least in a portion (Z1) of said sensitive layer (6), a curved bonding wire (10) adapted to connect one part (Z) of said metal layer (8) to said substrate (3, 11), a scintillator overlapping said sensitive layer (6), the sensor being **characterized in that** at least said part (Z) of said metal layer (8) is spaced apart from said scintillator (1), so that said bonding wire (10) does not interfere with the scintillator (1).

2. A sensor according to claim 1, further comprising a transparent layer (14) interposed between said sensitive layer (6) and said scintillator (1).

3. A sensor according to claim 2, wherein said transparent layer is made of epoxylic material.

4. A sensor according to claim 1, wherein one edge is tapered in correspondence with said part (Z) of said metal layer (8).

5. A sensor according to claim 4, where said taper is obtained on a first face (71) of the sensor comprising said sensitive layer (6), being a second face (72) opposite to said first flat face (71).

6. A sensor according to claim 4 or 5, further comprising a layer of fluxible filling material (91).

7. A sensor according to claim 6, wherein said fluxible layer is of grease and/or glue and/or resin (91) is further adapted to serve an optical function of filtering a radiation crossing the scintillator (1).

8. A sensor according to one of the preceding claims, further comprising a dielectric layer (9) covering a portion of the sensitive layer (6) not directly covered by said metal layer (8).

9. A method of manufacturing a sensor for detecting an electromagnetic radiation, comprising a substrate (3) having an inactive layer (7) attached/formed thereon which has a sensitive layer (6) attached/formed thereon, a metal layer (8) being attached at least in a portion (Z1) of said sensitive layer (6), at least one bonding wire (10) bending towards said substrate (3) branching from a part (Z) of said metal layer, a scintillator (1) overlapping said sensitive layer (6); the method comprising a step of tapering the thickness of at least one edge of the sensor so that said part (Z) of said metal layer (8) is at least partially spaced out from said scintillator (1).

10. A method according to claim 9, further comprising a physical etching procedure adapted to carry out a complete cut of the inactive layer (7).
